Europäisches Patentamt

European Patent Office

Office européen des brevets

(19)

(11) Publication number: 0 489 156 A1

## EUROPEAN PATENT APPLICATION
### published in accordance with Art. 158(3) EPC

(12)

(21) Application number: 89909626.7

(22) Date of filing: 24.08.89

(86) International application number:
PCT/JP89/00868

(87) International publication number:
WO 91/03141 (07.03.91 91/06)

(51) Int. Cl.⁵: **H05B 33/10**, H05B 33/14, H05B 33/18

(43) Date of publication of application:
**10.06.92 Bulletin 92/24**

(84) Designated Contracting States:
**DE FR GB NL**

(71) Applicant: **KABUSHIKI KAISHA KOMATSU SEISAKUSHO**
**3-6, Akasaka 2-chome**
**Minato-ku Tokyo 107(JP)**

(72) Inventor: **TANDA, Satoshi**
**8-2, Kokufu-hongo Oiso-cho**
**Naka-gun Kanagawa-ken 259-01(JP)**
Inventor: **NIRE, Takashi**
**3-18-11, Nakahara Hiratsuka-shi**
**Kanagawa-ken 254(JP)**

(74) Representative: **Allam, Peter Clerk et al**
**LLOYD WISE, TREGEAR & CO. Norman House 105-109 Strand**
**London WC2R 0AE(GB)**

(54) THIN-FILM EL ELEMENT.

(57) A thin-film EL element which is constructed to produce blue light of high brightness on a low voltage. The thin-film EL element is composed of a light-emitting member of SrS that contains Ce, K and Cl as luminescence center impurities. The concentration of Ce in the light-emitting member is 0.5 % to 1.0 %, and the ratio of Cl to Ce (Cl/Ce) is 2 or smaller. Further, the light-emitting layer, Sr, S, Ce and KCl are vaporized from four different sources, and are coupled together on the substrate by the multiple vapor deposition method.

FIG. 2

## Technical Field of the Invention

The present invention concerns a thin film EL (electroluminescence) device and, more in particular, it relates to a thin film EL device capable of obtaining blue luminescence at high luminocity by a low voltage driving.

## Background Art of the Invention

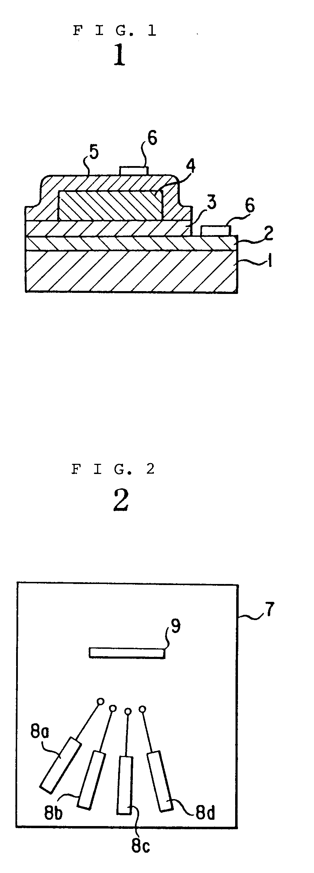

Generally, a thin film EL device has a dual dielectric structure as shown in Fig. 1, in which a transparent electrode 2 made of tin oxide ($SnO_2$), etc., a first dielectric member 3 made of tantalum pentoxide ($Ta_2O_5$), etc., a light emission layer 4, a second dielectric member 5 made of tantalum pentoxide ($Ta_2O_5$), etc. and metal electrodes 6, 6 made of aluminum (Al), etc. are successively laminated on a transparent substrate 1, and constituted such that blue light is emitted by applying a strong electric field to both of the electrodes 2, 6 and the light is taken out from the transparent substrate 1.

Then, as the conventional constituent material for the light emission layer 4 for blue luminescence ZnS:Tm, F, SrS:Ce, Cl, SrS:Ce, K, Cl have been studied and developed.

There have been problems in the conventional constituent materials for the light emission layer 4 described above that no luminocity can be obtained at all in the case of ZnS:Tm,F no practical luminocity can be obtained for SrS:Ce, Cl and SrS:Ce, K, Cl and, referring to the color of the luminescence, green ingredient rather than blue is emitted strongly.

It is considered that the foregoing problems are caused since the light emission layer is formed into a film by means of an electron beam method and material prepared by sintering SrS and $CeCl_3$ or SrS, $CeCl_3$ and KCl is used therefor and, accordingly, the ratio of concentration between Cl and Ce in the thin SrS film (Cl/Ce) is greater than 2 and Cl is contained by more than twice of Ce.

## Summary of the Invention

The present invention has been accomplished in view of the foregoing situations and the object thereof is to provide a thin film EL device capable of obtaining blue luminescence at high luminocity by low voltage driving and enabling use as a blue emission source for full color EL-display.

For attaining the foregoing object, it is provided in the first aspect of the present invention, a thin film EL device having as a light emission layer, a thin film in which Ce, K and Cl are contained as an emission center impurity in a emission matrix comprising SrS, the concentration of Ce in the emission matrix is from 0.5% to 1.0% and the Cl to Ce ratio (Cl/Ce) is set to less than 2.

In the second aspect of the present invention, there is provided a thin film EL device as defined in the first feature, in which the light emission layer is prepared by a multiple vapor deposition method of evaporating Sr, S, Ce and KCl from four systems of separate evaporation sources respectively and then combining them on a substrate.

These and other objects, features, as well as the advantages of the present invention will be come apparent to those skilled in the art by descriptions made in conjuction with the following descriptions and appended drawings in which specific preferred embodiments according to the principle of the present invention are shown as examples.

## Brief Explanation of the Drawings

Fig. 1 is a schematic transversal cross sectional view illustrating a general structure of a thin film EL device,
Fig. 2 is a principle view for a method of forming a light emission layer,
Fig. 3 is a graph illustrating luminance - voltage characteristics and Fig. 4 is a graph illustrating spectrum in the preferred embodiment of the present invention in comparison with the spectrum in a conventional example.

## Detailed Description for Preferred Embodiment

An embodiment of the present invention will be explained referring to the appended drawings.

The laminate structure of the thin film EL device according to the present invention is quite identical with that of conventional one shown in Fig. 1 but the constitution of the light emission layer 4 is different.

That is, the light emission layer 4 contains Ce, K and Cl as an emission center impurity in an emission matrix made of SrS and the concentration of Ce as the emission center impurity in the emission matrix is from 0.5 to 1.0% and the ratio of Cl to Ce (Cl/Ce) is set to lower than 2.

The light emission layer is prepared by a so-called multi-system deposition method (MSD method) in which SrS constituting the emission matrix and Ce, KCl (compound) as the emission center impurity are evaporated from separate evaporization sources respectively, that is, from four systems, which are then combined on a substrate.

The multi-system deposition method is, for example, adapted as shown in Fig. 2 such that constituent elements Sr, S for the light emission matrix and emission center impurity Ce, KCl (compound) are placed respectively in separate crucibles 8a, 8b, 8c and 8d in a vacuum vessel 7 set to a vacuum degree, for example, of about $10^{-3}$ - $10^{-7}$, which are then heated under temperature control independently of each other and columnar crystals the emission center impurity are deposited with uniform distribution on the substrate 9 by controlling the evaporation amount for each of them such that the light emission layer formed has a stoichiometrical composition.

The dielectric members 3, 5 on both sides of the light emission layer are formed by means of a sputtering method.

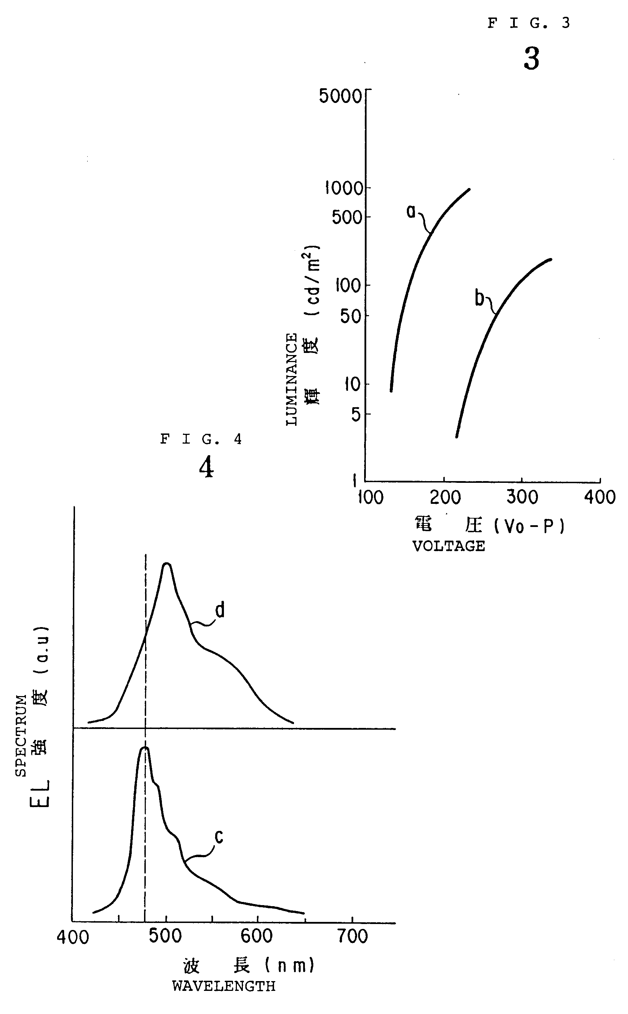

Fig. 3 is a graph illustrating luminance-voltage characteristics, in which respective data are shown, i.e., a for the thin film EL device having the light emission layer according to the present invention and b for a conventional thin film EL device with the $\overline{Cl}$ to Ce ratio : Cl/Ce > 2 in the light emission layer.

As apparent from the figures, the thin film EL device according to the present invention can provide a higher luminocity at a lower voltage than usual.

Fig. 4 illustrates spectrum, in which respective data are shown, i.e., c for a thin film EL device having the light emission layer according to the present invention and d for a conventional example.

As apparent from the figures, the thin EL device according to the present invention has a shorter wavelength as compared with that of the conventional case and blue luminescence with intense blue ingredient is emitted.

## Claims

1. A thin film EL device having, as a light emission layer, a thin film in which Ce, K and Cl as an emission center impurity are contained in an emission matrix comprising SrS, the concentration of Ce in the light emission matrix is from 0.5% to 1.0% and the ratio of Cl to Ce (Cl/Ce) is set to less than 2.

2. A thin film El device as defined in claim 1, wherein the light emission layer is prepared by a multi-system vapor deposition method of evaporating Sr, S, Ce and KCl from four systems of separate evaporation sources respectively and then combining them on a substrate.

F I G. 1
1

F I G. 2
2

F I G. 3

3

Fig. 3 — LUMINANCE 輝 度 (cd/m²) vs 電 圧 (Vo-P) VOLTAGE

F I G. 4

4

Fig. 4 — EL SPECTRUM 強 度 (a.u) vs 波 長 (n m) WAVELENGTH

5

# INTERNATIONAL SEARCH REPORT

International Application No  PCT/JP89/00868

**I. CLASSIFICATION OF SUBJECT MATTER** (if several classification symbols apply, indicate all) [6]

According to International Patent Classification (IPC) or to both National Classification and IPC

Int. Cl$^4$     H05B33/10, 33/14, 33/18

**II. FIELDS SEARCHED**

| Minimum Documentation Searched [7] | |
|---|---|
| Classification System | Classification Symbols |
| IPC | H05B33/00 - 33/28 |

Documentation Searched other than Minimum Documentation
to the Extent that such Documents are Included in the Fields Searched [8]

| | |
|---|---|
| Jitsuyo Shinan Koho | 1967 - 1989 |
| Kokai Jitsuyo Shinan Koho | 1971 - 1989 |

**III. DOCUMENTS CONSIDERED TO BE RELEVANT [9]**

| Category [*] | Citation of Document, [11] with indication, where appropriate, of the relevant passages [12] | Relevant to Claim No. [13] |
|---|---|---|
| Y | JP, A, 61-260593 (Fujitsu Ltd.) 18 November 1986 (18. 11. 86) (Family : none) | 1, 2 |
| Y | JP, A, 61-34890 (Nippon Telegraph & Telephone Corporation) 19 February 1986 (19. 02. 86) (Family : none) | 1, 2 |
| Y | JP, A, 57-102983 (Matsushita Electric Ind. Co., Ltd.) 26 June 1982 (26. 06. 82) (Family : none) | 1 |

* Special categories of cited documents: [10]

"A" document defining the general state of the art which is not considered to be of particular relevance

"E" earlier document but published on or after the international filing date

"L" document which may throw doubts on priority claim(s) or which is cited to establish the publication date of another citation or other special reason (as specified)

"O" document referring to an oral disclosure, use, exhibition or other means

"P" document published prior to the international filing date but later than the priority date claimed

"T" later document published after the international filing date or priority date and not in conflict with the application but cited to understand the principle or theory underlying the invention

"X" document of particular relevance; the claimed invention cannot be considered novel or cannot be considered to involve an inventive step

"Y" document of particular relevance; the claimed invention cannot be considered to involve an inventive step when the document is combined with one or more other such documents, such combination being obvious to a person skilled in the art

"&" document member of the same patent family

**IV. CERTIFICATION**

| Date of the Actual Completion of the International Search | Date of Mailing of this International Search Report |
|---|---|
| November 6, 1989 (06. 11. 89) | November 20, 1989 (20. 11. 89) |

| International Searching Authority | Signature of Authorized Officer |
|---|---|
| Japanese Patent Office | |

Form PCT/ISA/210 (second sheet) (January 1985)